Europäisches Patentamt

European Patent Office

Office européen des brevets

(11) Veröffentlichungsnummer: **0 297 276 B1**

(12) **EUROPÄISCHE PATENTSCHRIFT**

(45) Veröffentlichungstag der Patentschrift: **18.03.92**

(21) Anmeldenummer: **88108268.9**

(22) Anmeldetag: **24.05.88**

(51) Int. Cl.⁵: **G11C 8/00**, G11C 5/14

(54) **Generatorschaltung.**

(30) Priorität: **10.06.87 DE 3719360**

(43) Veröffentlichungstag der Anmeldung:
**04.01.89 Patentblatt 89/01**

(45) Bekanntmachung des Hinweises auf die
Patenterteilung:
**18.03.92 Patentblatt 92/12**

(84) Benannte Vertragsstaaten:
**AT DE FR GB IT NL**

(56) Entgegenhaltungen:
**EP-A- 0 061 271**
**EP-A- 0 061 513**
**EP-A- 0 092 809**

(73) Patentinhaber: **SIEMENS AKTIENGESELL-
SCHAFT
Wittelsbacherplatz 2
W-8000 München 2(DE)**

(72) Erfinder: **Fuchs, Hans Peter, Dipl.-Phys.
Mitterhoferstrasse 19
W-8000 München 21(DE)**

Rank Xerox (UK) Business Services

## Beschreibung

Die Erfindung betrifft eine Generatorschaltung nach dem Oberbegriff des Patentanspruches 1.

Gattungsgemäße Generatorschaltungen sind beispielsweise in integrierten Halbleiterspeichern, insbesondere in DRAM's eingesetzt als sogenannte Wortleitungs-Spannungsgeneratoren. Sinn und Zweck solcher Generatorschaltungen bei DRAM's beispielsweise ist es, eine Taktspannung zur Verfügung zu stellen, die mindestens um den Betrag der Einsatzspannung der Auswahltransistoren der Speicherzellen über der Versorgungsspannung der gesamten Schaltungsanordnung liegt. Meist ist diese Taktspannung um den Betrag der halben Versorgungsspannung überhöht. Dies ermöglicht beispielsweise das Einschreiben einer log. 1 als zu speichernde Information in eine ausgewählte Speicherzelle mit ihrem vollen Spannungspegel, d.h. nicht etwa vermindert um den Betrag der obengenannten Einsatzspannung.

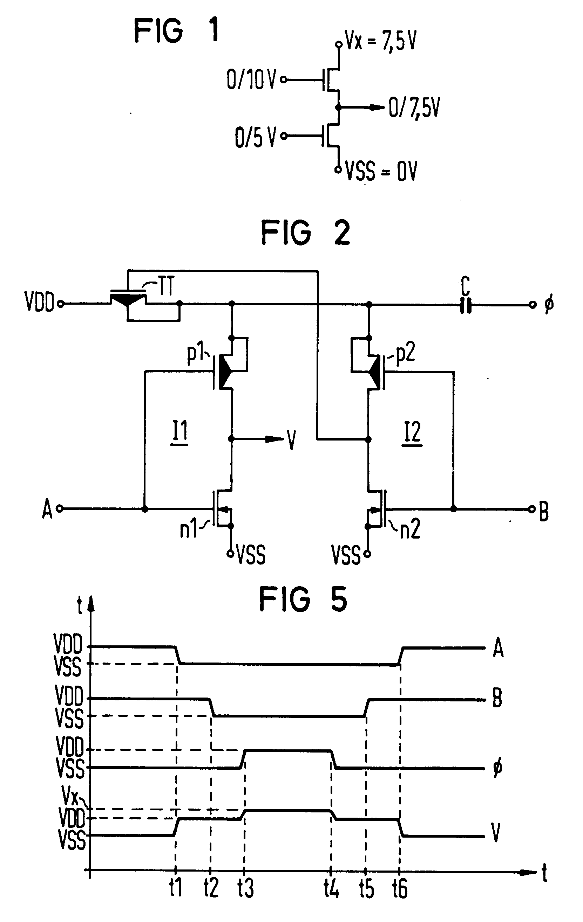

Bislang wurden zu diesem Zweck beispielsweise zwei in Serie zueinander geschaltete n-Kanal-Transistoren verwendet. Sie sind (vgl. FIG 1) zwischen der Bezugsspannung VSS (z.B. 0 V) und der gegenüber der Versorgungsspannung VDD (z.B. 5 V) überhöhten Spannung Vx (z.B. 7,5 V) angeordnet. Zwischen den beiden Transistoren liegt als Ausgang die Taktspannung V an, die Pegel von VSS und Vx aufweist (je nach Schaltzustand). Während der eine Transistor mit üblichen Pegeln (Bezugsspannung VSS und Versorgungsspannung VDD) am Gate betrieben wird, liegen am Gate des anderen Transistors als Pegel abwechselnd die Bezugsspannungen VSS und eine gegenüber der Taktspannung Vx nochmals überhöhte Spannung an, die beispielsweise das Doppelte der Versorgungsspannung VDD beträgt (z.B. 10 V). Eine solche Schaltung ist beispielsweise aus EP-A-0 061 271 bekannt.

Diese nochmals überhöhte Spannung erreicht nun die Größenordnung der Durchbruchsspannung der zwischen den $n^+$-Diffusionsgebieten und dem p-Substrat der Transistoren ausgebildeten Dioden (n-Kanal-Technologie angenommen). Damit ist die Gefahr von Spannungsdurchbrüchen und Beschädigungen des Halbleitermaterials gegeben.

Aufgabe der vorliegenden Erfindung ist es, hier Abhilfe zu schaffen und eine Generatorschaltung anzugeben, die diese doppelt überhöhten Spannungswerte nicht benötigt.

Diese Aufgabe wird bei einer gattungsgemäßen Generatorschaltung gelöst durch die kennzeichnenden Merkmale des Patentanspruches 1.

Vorteilhafte Aus- und Weiterbildungen sind in Unteransprüchen gekennzeichnet.

Die vorliegende Erfindung wird nun anhand der FIG. 2 bis 5 näher erläutert.

Die FIG. 2 bis 4 zeigen vorteilhafte Ausgestaltungen der Erfindung.

Die FIG. 5 zeigt ein Zeitdiagramm.

Die in FIG. 2 gezeigte vorteilhafte Ausführungsform der Erfindung zeigt zwei CMOS-Inverter I1, I2. Der erste (I1) der beiden CMOS-Inverter ist eingangsmäßig mit einem ersten Taktsignal A verbunden. Sein Ausgang führt die erzeugte Taktspannung V der Generatorschaltung. Der zweite (I2) der beiden CMOS-Inverter ist eingangsmäßig mit einem zweiten Taktsignal B verbunden. Jeder Inverter I1, I2 enthält, wie üblich, einen Transistor p1, p2 vom ersten Leitungstyp und einen Transistor n1, n2 vom zweiten Leitungstyp. Der erste Leitungstyp sei hier mit p-Kanal angenommen. Entsprechend ist der zweite Leitungstyp mit n-Kanal angenommen.

Die Zuordnung kann unter Berücksichtigung der elektrischen Bedingungen auch umgekehrt sein. Während die Sourceanschlüsse der Transistoren n1, n2 vom zweiten Leitungstyp, wie üblich, mit dem Bezugspotential VSS verbunden sind, sind die Sourceanschlüsse der Transistoren p1, p2 vom ersten Leitungstyp über einen Transfertransistor TT vom ebenfalls ersten Leitungstyp mit dem Versorgungspotential VDD verbunden. Sie sind außerdem über eine Kapazität C mit einem Pumpsignal Ø verbunden. Das Gate des Transfertransistors TT ist mit dem Ausgang des zweiten CMOS-Inverters I2 verbunden.

Die Funktion dieser Schaltung läßt sich am besten anhand des Zeitdiagramms nach FIG. 5 erklären: Bis zum Zeitpunkt t1 ist die Taktspannung V als Ausgang des ersten Inverters I1 aufgrund des ersten Taktsignales A auf log. 0 entsprechend ungefähr VSS. Aufgrund des zweiten Taktsignales B ist der Transfertransistor TT bis zum Zeitpunkt t2 leitend. Dies hat zur Folge, daß die Sources der Transistoren p1, p2 vom ersten Leitungstyp der Inverter I1, I2 bis zum Zeitpunkt t2 auf log. 1 entsprechend ungefähr Versorgungspotential VDD vorgeladen sind.

Aufgrund des ersten Taktsignales A weist die Taktspannung V ab dem Zeitpunkt t1 das Versorgungspotential VDD auf. Dies bleibt so bis zum Zeitpunkt t3. Im Zeitpunkt t3 und nachfolgend sind beide Transistoren p1, p2 vom ersten Leitungstyp der Inverter I1, I2 aufgrund der beiden Taktsignale A und B leitend. Dies bedeutet u.a., daß der Transfertransistor TT (seit dem Zeitpunkt t2) gesperrt ist. Zum Zeitpunkt t3 wechselt das Pumpsignal Ø seinen Zustand von log. 0 (in etwa VSS) auf log. 1 (in etwa VDD). Dadurch erfolgt über die Kapazität C eine Ladungsverschiebung ("boosting") in Richtung über das Versorgungspotential VDD hinaus (die Ladung kann ja nicht über den gesperrten Transfertransistor TT zum Versorgungspotential VDD hin abfließen!). Da die beiden Transistoren p1, p2 vom ersten Leitungstyp noch leitend sind, wirkt sich die Ladungsverschiebung auf beide Transistoren p1,p2 aus. Somit steigt die Taktspannung V über das Versorgungspotential VDD hinaus an auf einen Wert Vx, der größenordnungsmäßig ca. um die Hälfte des Versorgungspotentiales VDD über diesem liegt (d.h. also ca. 7,5 V). Ein genauer Wert dafür hängt zum einen vom Versorgungspotential VDD ab und zum anderen von der Dimensionierung der gesamten Schaltung.

Zum Zeitpunkt t4 geht das Pumpsignal Ø auf log. 0, die Ladungsverschiebung ist beendet und das Ausgangssignal V weist wieder den Wert des Versorgungspotentiales VDD auf. Zum Zeitpunkt t5 wird der Transfertransistor TT wieder leitend wegen des zweiten Taktsignales B. Im Zeitpunkt t6 tritt der Ausgangszustand wieder ein: Die Taktspannung V weist wegen des ersten Taktsignales A das Bezugspotential VSS auf.

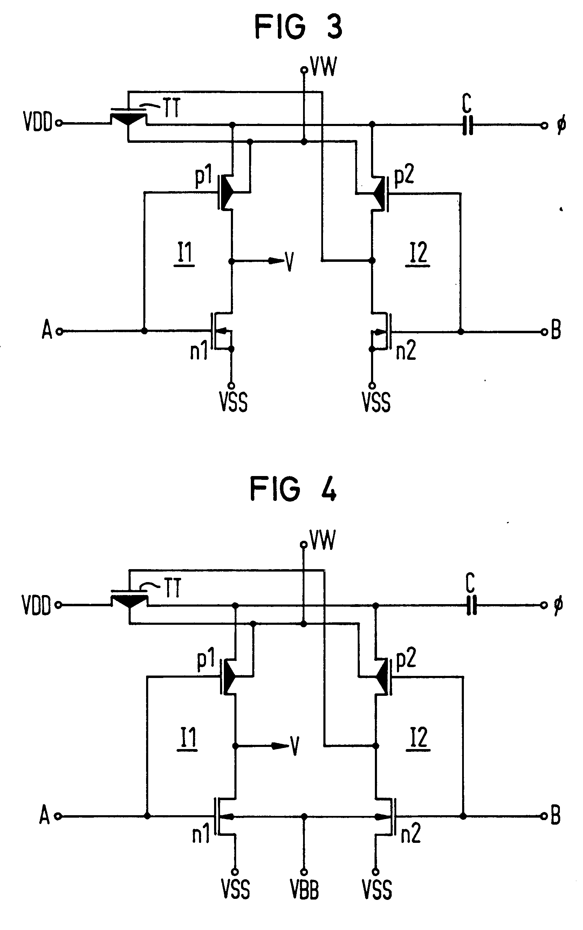

Bei der Ausführungsform nach FIG. 3 sind die (bei CMOS üblichen) wannenförmig ausgebildeten Substratbereiche der Transistoren p1, p2 vom ersten Leitungstyp der Inverter I1,I2 sowie des Transfertransistors TT mit einer Wannenspannung VW verbunden anstelle einer Verbindung mit der jeweiligen Source (siehe FIG. 2). Die Wannenspannung VW ist dabei mindestens so groß wie das größte in der Schaltung auftretende Potential, d.h. im vorliegenden Fall mindestens so groß wie das obengenannte Potential Vx der Taktspannung V.

Während bei der Ausführungsform nach den FIG. 2 und 3 die Substratbereiche der Transistoren vom zweiten Leitungstyp, d.h. also bei den gewählten Leitungstypzuordnungen die Substratbereiche der n-Kanal-Transistoren n1 und n2 der Inverter I1,I2 mit der Source des jeweiligen n-Kanal-Transistors n1,n2 verbunden sind und meist auf Bezugspotential VSS liegen, sind diese Substratbereiche bei der Ausführungsform nach FIG. 4 mit einer separaten Substratvorspannung VBB verbunden.

Wenn auch die vorliegende Erfindung anhand einer n-Wannen-CMOS-Technologie bei den FIG. 2 bis 4 erklärt wurde, so ist für den Fachmann doch leicht einzusehen, daß diese Erfindung auch mittels p-Wannen-CMOS-Technologie bei entsprechender Variation der Schaltungsanordnung allein unter Anwendung entsprechender Fachkenntnisse aus der vorliegenden Offenbarung heraus realisierbar ist (z.B. in FIG 2 durch Vertauschen der Potentiale VSS und VDD sowie der p-Kanal-Transistoren mit den n-Kanal-Transistoren).

**Patentansprüche**

1. Generatorschaltung in einer integrierten Halbleiterschaltung zur Erzeugung einer Taktspannung, die eine gegenüber einem Versorgungspotential der Generatorschaltung überhöhte Spannung aufweist, **gekennzeichnet durch** folgende Merkmale:
   - ein erster CMOS-Inverter (I1) ist eingangsmäßig mit einem ersten Taktsignal (A) verbunden, sein Ausgang führt die Taktspannung (V) als Ausgangssignal der Generatorschaltung;
   - ein zweiter CMOS-Inverter (I2) ist eingangsmäßig mit einem zweiten Taktsignal (B) verbunden;
   - die Sourceanschlüsse der Transistoren (p1,p2) eines ersten Leitungstyps der beiden Inverter (I1,I2) sind einerseits über einen Transfertransistor (TT) mit dem Versorgungspotential (VDD) verbunden und andererseits über eine Kapazität (C) mit einem Pumpsignal (Ø);
   - das Gate des Transfertransistors (TT) ist mit dem Ausgang des zweiten CMOS-Inverters (I2) verbunden; - der Transfertransistor (TT) ist ebenfalls vom ersten Leitungstyp.

2. Generatorschaltung nach Anspruch 1, **dadurch gekennzeichnet,** daß die Substratbereiche der Transistoren vom ersten Leitungstyp (p1,p2;TT) jeweils mit der dem jeweiligen Transistor zugehörigen Source verbunden sind.

3. Generatorschaltung nach Anspruch 1, **dadurch gekennzeichnet,** daß die Substratbereiche der Transistoren vom ersten Leitungstyp (p1,p2;TT) mit einer Wannenspannung (VW) verbunden sind, die mindestens gleich groß ist wie das höchste in der Generatorschaltung auftretende Potential.

4. Generatorschaltung nach einem der Ansprüche 1 bis 3, **dadurch gekennzeichnet,** daß die Substratbereiche der restlichen Transistoren (n1,n2) der Inverter (I1,I2), die von einem zweiten Leitungstyp sind, der dem ersten Leitungstyp entgegengesetzt ist, mit der Source dieser Transistoren (n1,n2) verbunden sind.

5. Generatorschaltung nach einem der Ansprüche 1 bis 3, **dadurch gekennzeichnet,** daß die Substratbereiche der restlichen Transistoren (n1,n2) der Inverter (I1,I2), die von einem zweiten Leitungstyp sind, der dem ersten Leitungstyp entgegengesetzt ist, mit einer separaten Substratvorspannung (VBB) verbunden sind.

6. Generatorschaltung nach einem der Ansprüche 1 bis 5, **dadurch gekennzeichnet,** daß die Substratbereiche der Transistoren vom ersten Leitungstyp (p1,p2;TT) in einer Wanne vom entgegengesetzten Leitungstyp innerhalb des Substrates der Transistoren vom zweiten Leitungstyp (n1,n2) angeordnet sind.

7. Generatorschaltung nach einem der Ansprüche 1 bis 5, **dadurch gekennzeichnet, daß** die Substratbereiche der Transistoren vom zweiten Leitungstyp (n1,n2) in einer Wanne vom entgegengesetzten Leitungstyp innerhalb des Substrates der Transistoren vom ersten Leitungstyp (p1,p2;TT) angeordnet sind.

## Claims

1. Generator circuit in an integrated semiconductor circuit for generating a clock voltage having a voltage which is raised with respect to a supply potential of the generator circuit, characterised by the following features:
   - a first CMOS inverter (I1) is connected on the input side to a first clock signal (A) and its output carries the clock voltage (V) as output signal of the generator circuit;
   - a second CMOS inverter (I2) is connected on the input side to a second clock signal (B);
   - the source terminals of the transistors (p1,p2) of a first conduction type of the two inverters (I1,I2) are connected, on the one hand, to the supply potential (VDD) via a transfer transistor (TT) and, on the other hand, to a pump signal (ø) via a capacitor (C);
   - the gate of the transfer transistor (TT) is connected to the output of the second CMOS inverter (I2);
   - the transfer transistor (TT) is also of the first conduction type.

2. Generator circuit according to Claim 1, characterised in that the substrate regions of the transistors of the first conduction type (p1,p2;TT) are each connected to the source associated with the respective transistor.

3. Generator circuit according to Claim 1, characterised in that the substrate regions of the transistors of the first conduction type (p1,p2;TT) are connected to a trough voltage (VW) which is at least as high as the highest potential occurring in the generator circuit.

4. Generator circuit according to one of Claims 1 to 3, characterised in that the substrate regions of the remaining transistors (n1,n2) of the inverters (I1,I2), which are of a second conduction type opposite to the first conduction type, are connected to the source of these transistors (n1,n2).

5. Generator circuit according to one of Claims 1 to 3, characterised in that the substrate regions of the remaining transistors (n1,n2) of the inverters (I1,I2), which are of a second conduction type opposite to the first conduction type, are connected to a separate substrate bias voltage (VBB).

6. Generator circuit according to one of Claims 1 to 5, characterised in that the substrate regions of the transistors of the first conduction type (p1,p2;TT) are disposed in a trough of opposite conduction type inside the substrate of the transistors of the second conduction type (n1,n2).

7. Generator circuit according to one of Claims 1 to 5, characterised in that the substrate regions of the transistors of the second conduction type (n1,n2) are disposed in a trough of the opposite conduction type inside the substrate of the transistors of the first conduction type (p1,p2;TT).

## Revendications

1. Circuit générateur dans un circuit intégré à semiconducteurs, qui sert à produire une tension de cadence et qui possède une tension accrue par rapport à un potentiel d'alimentation du circuit générateur, caractérisé par les particularités suivantes :
   - un premier inverseur CMOS (I1) reçoit, côté entrée, un premier signal de cadence (A) et sa sortie délivre la tension de cadence (V) en tant que signal de sortie du circuit générateur;
   - un second inverseur CMOS (I2) reçoit, côté entrée, un second signal de cadence (B);
   - les bornes de source des transistors (p1,p2) possédant un premier type de conductivité des deux inverseurs (I1,I2) reçoivent, d'une part, par l'intermédiaire d'un transistor de transfert (TT), le potentiel d'alimentation (VDD), et, d'autre part, par l'intermédiaire d'une capacité (C), un signal de pompage (ø);
   - la grille du transistor de transfert (TT) est raccordée à la sortie du second inverseur CMOS (I2);
   - le transistor de transfert (TT) possède également le premier type de conductivité.

2. Circuit générateur suivant la revendication 1, caractérisé par le fait que les parties du substrat des transistors possédant le premier type de conductivité (p1,p2; TT) sont raccordées respectivement à la source associée au transistor respectif.

3. Circuit générateur suivant la revendication 1, caractérisé par le fait que les zones du substrat du transistor possédant le premier type de conductivité (p1,p2;TT) sont placées à une tension de cuvette (VW), qui est au moins égale au potentiel maximum apparaissant dans le circuit générateur.

4. Circuit générateur suivant l'une des revendications 1 à 3, caractérisé par le fait que les zones du substrat des autres transistors (n1,n2) des inverseurs (I1,I2), qui possèdent le second type de conductivité opposé au premier type de conductivité, sont raccordées à la source de ces transistors (n1,n2).

5. Circuit générateur suivant l'une des revendications 1 à 3, caractérisé par le fait que les zones de substrat des autres transistors (n1,n2) des inverseurs (I1,I2), qui possèdent le second type de conductivité opposé au premier type de conductivité, sont placées à une tension séparée de polarisation de substrat (VBB).

6. Circuit générateur suivant l'une des revendications 1 à 5, caractérisé par le fait que les zones de substrat des transistors possédant le premier type de conductivité (p1,p2;TT) sont disposées dans une cuvette possédant le type de conductivité opposé, à l'intérieur du substrat des transistors (n1,n2) possédant le second type de conductivité.

7. Circuit générateur suivant l'une des revendications 1 à 5, caractérisé par le fait que les zones du substrat des transistors (n1,n2) du second type de conductivité sont disposées dans une cuvette possédant le type de conductivité opposé, à l'intérieur du substrat des transistors possédant le premier type de conductivité (p1,p2;TT).

# FIG 1

Vx = 7,5V

0/10 V

0/ 7,5V

0/5 V

VSS = 0V

# FIG 2

VDD

TT

C

φ

p1

p2

I1

V

I2

A

n1

VSS

VSS

n2

B

# FIG 5

t

VDD
VSS
A

VDD
VSS
B

VDD
VSS
φ

Vx
VDD
VSS
V

t1  t2  t3        t4  t5  t6        t

# FIG 3

# FIG 4